# EUROPÄISCHE PATENTSCHRIFT

(11) **EP 2 246 906 B1**
(45) Veröffentlichungstag und Bekanntmachung des Hinweises auf die Patenterteilung: **25.05.2011**
(21) Anmeldenummer: 09015833.8
(22) Anmeldetag: 22.12.2009
(51) Int. Cl.: H01L 31/18, H01L 31/05

(54) **Solarzellen-String**
Solar cell string
Chaîne de cellules solaires

(43) Veröffentlichungstag der Anmeldung: 03.11.2010
(73) Patentinhaber: KIOTO Photovoltaics GmbH, 9300 St. Veit (AT)
(72) Erfinder: Eusch, Ingram, 9500 Villach (AT); Frank, Rudolf, 9064 Pischeldorf (AT); Kogler, Armin, 9330 Treibach (AT)
(74) Vertreter: Becker, Thomas

(56) Entgegenhaltungen:
- EP-A1- 1 909 333
- WO-A2-2009/136251
- US-A1- 2009 236 328

## Beschreibung

Die Erfindung betrifft einen Solarzellen-String, wobei ein "String" mehrere, über elektrisch leitfähige Streifen miteinander verbundene Solarzellen bezeichnet.

Ein bekannter Solarzellen-String umfasst demnach folgende Merkmale:
- Der String besteht aus mehreren, im Abstand hintereinander angeordneten Solarzellen,
- benachbarte Solarzellen sind jeweils über mindestens zwei elektrische Leiterbahnen verbunden,
- jede Leiterbahn ist mit einem ersten Abschnitt mit einer Oberseite einer Solarzelle fest verbunden und mit einem zweiten Abschnitt mit einer Unterseite der benachbarten Solarzelle fest verbunden.

Üblicherweise verbindet ein Paar (2) Leiterbahnen die Oberseite einer Solarzelle mit der Unterseite einer benachbarten Solarzelle. Am Anfang und/oder Ende des Strings sind elektrische Anschlüsse vorgesehen.

Üblicherweise bestehen die Leiterbahnen aus einem Grundkörper und einer lötbaren Beschichtung. Die Leiterbahnen sind dann auf den Solarzellen aufgelötet.

Um einzelne Solarzellen mit Leiterbahnen zu einem kompletten Solarzellen-String zu verarbeiten sind verschiedene Verarbeitungsstufen und Behandlungsschritte notwendig. Dabei kommt es wesentlich darauf an, eine exakte Positionierung der einzelnen Solarzellen und der einzelnen Leiterbahnen zu gewährleisten, so dass auch die Kombination mehrerer Solarzellen mit mehreren Leiterbahnen zu einem Solarzellen-String in der gewünschten und notwendigen Ausrichtung (Zusammenstellung) erfolgt. Dies ist unter anderem deshalb schwierig, weil die Solarzellen extrem dünn (circa 200 µm) und spröde sind und die Leiterbahnen mit einer Breite von beispielsweise 0,5 bis 3 mm und einer Dicke von maximal 0,2 bis 1 mm schmale Bänder sind, die nicht ohne weiteres in den gewünschten Flächenkontakt mit der Oberseite/Unterseite der Solarzelle gebracht werden können.

Es ist bekannt, die Leiterbahnen über eine Saugeinrichtung zur Solarzelle zu transportieren und dort abzulegen sowie anschließend mit einem Niederhalter gegenüber der Solarzelle zu fixieren, und zwar auch während des folgenden Lötvorgangs. Die Niederhalter werden erst wieder abgehoben, nachdem die entsprechende Zelle die Lötstation verlassen hat.

Eine entsprechende Anlage mit einem Niederhalter ist aus der DE 10 2006 007 447 A1 bekannt. Der Niederhalter besteht aus einem Rahmen, der an seinen beiden Randbereichen Auflageflächen aufweist, die in der Funktionsposition auf Transportbändern aufliegen und ein Fenster aufweisen, in oder neben dem Niederhalterköpfe angeordnet sind, die jeweils eine Niederhalternadel aufweisen und schwenkbar am Rahmen gehalten sind. Die Nadeln drücken beim Aufsetzen des Niederhalters auf die Leiterbahn und drücken damit die Leiterbahn auf die Solarzelle. Dabei wird Wert darauf gelegt, dass die Kraft, mit der die Leiterbahnen fixiert werden, nur in einer Richtung wirkt. Die genannten Nadeln werden in so genannten Niederhalterköpfen gelagert, die schwenkbeweglich am Rahmen angelenkt sind.

Der bekannte Niederhalter ist konstruktiv sehr komplex, die Nadeln führen zu sehr kleinen Druckpunkten, wobei die Leiterbahn leicht beschädigt werden kann. Darüber hinaus ist eine Einstellung der Druckkraft in Bezug auf die Fläche der Leiterbahn ausgeschlossen und im Übrigen nur individuell über die Niederhalterköpfe möglich. Im Ergebnis weist der bekannte Solarzellen-String keine ausreichende Flächenverbindung von Leiterbahn und Solarzelle auf.

Die US 2009/0236328 A1 zeigt einen Lötapparat, bei dem die Leiterbahnen über vertikal verschiebbare Andrückstifte während des Lötvorgangs gehalten werden. Die Andrückstifte weisen eine freie, planare Stirnfläche auf.

Der Erfindung liegt die Aufgabe zu Grunde, einen Solarzellen-String anzubieten, der eine optimierte Verbindung von Leiterbahn und Solarzelle schafft.

Der erfindungsgemäße Solarzellen-String ist durch die Merkmale von Anspruch 1 definiert.

"Kalottenförmig" bedeutet, dass die Vertiefung keine unidirektionale Vertiefung (im technischen Sinne) ist, wie sie durch eine Nadel erreicht wird, wie im Stand der Technik, sondern beschreibt eine Vertiefung in der Leiterbahn, die sich über einen gewissen Flächenabschnitt der Leiterbahn erstreckt.

Dies setzt Niederhalter entsprechender Geometrie voraus, beispielsweise an Federn endseitig befestigte sphärische Körper in Kugel- oder Eiform, die auf die Leiterbahn drücken und einen entsprechenden dreidimensionalen Eindruck (die kalottenförmige Vertiefung) in der Leiterbahn hinterlassen. Das Verhältnis von Tiefe (senkrecht zur Leiterbahn-Oberfläche) zu Breite (größte Breite parallel zur Leiterbahn-Oberfläche) ist dabei typischerweise < 1:1, beispielsweise < 1:2 oder < 1:3 oder < 1:5, < 1:7 oder < 1:10. Bei einem nadelförmigen Einstich beträgt das Verhältnis > 1:1.

Vorzugsweise verläuft die Vertiefung vollständig innerhalb der zugehörigen Leiterbahn, das heißt die Vertiefung erstreckt sich nur bis kurz vor den Rand der entsprechenden Oberfläche der Leiterbahn.

Der Begriff "kalottenförmige Vertiefung" ist weiter als Vertiefung mit gewölbten Flanken definiert. Entsprechend geformte Druckkörper üben Kräfte in unterschiedlichsten Richtungen auf die Leiterbahn aus, so dass sowohl der Effekt des Andrückens (Niederdrückens) als auch die anschließende Verbindung von Leiterbahn und Solarzellen-Oberfläche verbessert wird.

Das Andrücken der Leiterbahn auf die Solarzelle kann zusätzlich verbessert werden, wenn ein Andrückkörper verwendet wird, der eine profilierte (strukturierte) Oberfläche aufweist, wodurch eine Vertiefung gebildet wird, die eine korrespondierende strukturierte (profilierte) Oberfläche aufweist, beispielsweise einen gerillten Wandabschnitt.

Dabei werden vielfältige Druckkräfte in unterschiedlichen Druckrichtungen über den Niederhalter auf die Leiterbahn und von der Leiterbahn auf die Solarzelle übertragen und damit während des anschließenden Lötvorgangs die Lötverbindung nachhaltig verbessert, insbesondere wird ein deutlich erhöhter Flächenkontakt zwischen Leiterbahn und Solarzelle erreicht, der für die elektrische Leitung wichtig ist.

Wie bereits ausgeführt hängt die konkrete Geometrie der Vertiefung insbesondere von der Geometrie des Niederhalters ab, der während des Andrückvorgangs mehr oder weniger stationär gegenüber der Leiterbahn gehalten wird. Insoweit kann die Vertiefung im Bereich der freien Oberfläche der zugehörigen Leiterbahn beispielsweise einen runden Querschnitt aufweisen, aber auch einen ovalen Querschnitt oder einen Querschnitt mit evolventenartigen Flanken.

Die Höhe der Vertiefung (senkrecht zur Oberfläche der Solarzelle) ist abhängig von der Dicke der Leiterbahn, der Druckkraft, mit der der Niederhalter auf die Leiterbahn gedrückt wird sowie der Geometrie des Druckkörpers. Üblicherweise entspricht die größte Höhe der Vertiefung (senkrecht zur Oberfläche der Solarzelle und Leiterbahn) maximal 70 % der Gesamtdicke der Leiterbahn (in gleicher Richtung wie die Vertiefung betrachtet), wobei ein Wert von 10% genügt, um die gewünschte Druckverteilung zu erreichen. Typische Werte sind 10-50 % oder 10-30 %.

Der Abstand der Vertiefungen (in Längsrichtung der entsprechenden Leiterbahn) beträgt nach einer Ausführungsform 1,0 bis 3,0 cm.

Der Querschnitt der Vertiefung an der freien Oberfläche der Leiterbahn beträgt insbesondere 0,5 bis 5 mm² mit üblichen Werten von 0,5 bis 2 mm².

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher erläutert.

Dabei zeigen, jeweils in schematisierter Darstellung:
- Figur 1:: Eine Seitenansicht eines Solarzellen-Strings,
- Figur 2:: Eine Aufsicht auf eine Solarzelle des Strings,
- Figur 3:: Eine Aufsicht auf eine Leiterbahn der Solarzelle nach Figur 2,
- Figur 4:: Einen Schnitt durch die Leiterbahn gemäß Figur 3,
- Figur 5:: Eine Seitenansicht eines Niederhalters.

In den Figuren sind gleiche oder gleichwirkende Bauteile mit gleichen Bezugsziffern dargestellt.

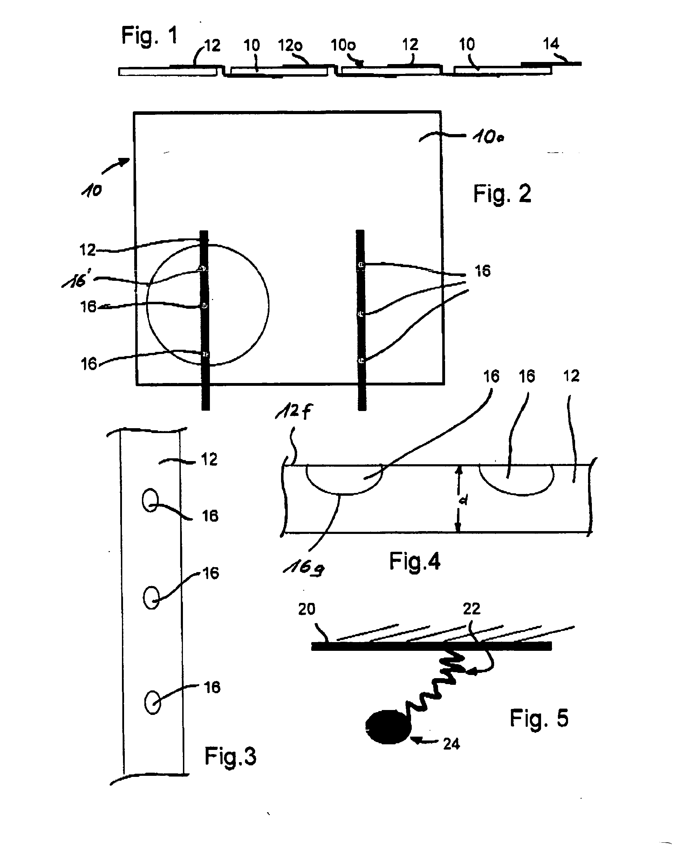

Figur 1 zeigt - stark schematisiert - einen Solarzellen-String aus vier Solarzellen 10, die über Leiterbahnen 12 verbunden sind, wobei jede Leiterbahn mit einem ersten Abschnitt 12o mit einer Oberseite 10o einer Solarzelle 10 und mit einem zweiten Abschnitt 12u mit einer Unterseite 10u der benachbarten Solarzelle 10 fest verbunden ist, und zwar durch Verlöten.

Endseitige elektrische Anschlüsse sind schematisch mit dem Bezugszeichen 14 skizziert.

Figur 2 zeigt eine Aufsicht auf eine Solarzelle 10 gemäß Figur 1, wobei zu erkennen ist, dass hier zwei Leiterbahnen 12 parallel zueinander im Abstand über die Oberseite 10o der Solarzelle 10 verlaufen.

Figur 3 zeigt in einer vergrößerten Darstellung gegenüber Figur 2, aber ebenfalls stark schematisiert, kalottenförmige Vertiefungen 16 zwischen Rändern 12r der Leiterbahn 12. Die Vertiefungen 16 verlaufen mittig in der Leiterbahn 12. Dies ergibt beim Andrücken mit zugehörigen Niederhaltern (Fig. 5) eine sehr gute Druckverteilung und damit eine gute Anpressung der Leiterbahn 12 auf die Solarzelle 10.

In der Aufsicht haben die kalottenförmigen Vertiefungen 16 einen etwa ovalen Querschnitt. Der Abstand benachbarter Vertiefungen 16 entspricht etwa dem drei- bis fünffachen der Öffnungsweite der Vertiefung 16 im Bereich der freien Oberfläche 12f der Leiterbahn 12.

Figur 3 zeigt den Bereich der kalottenförmigen Vertiefungen 16 im Querschnitt. Zu erkennen sind die gewölbten Flanken 16g der Vertiefungen 16, wobei die maximale Höhe der Vertiefungen 16 hier etwa der Hälfte der Dicke d der Leiterbahn 12 entspricht. Die in Figur 4 rechts dargestellte Vertiefung 16 ist gegenüber der links dargestellten Vertiefung etwas gekippt, wodurch verdeutlicht werden soll, dass die Vertiefungen 16 unter den gegebenen technischen Rahmenbedingungen nicht immer eine exakte symmetrische Geometrie aufweisen und nicht immer eine exakt mittige Position auf der Leiterbahn aufweisen sondern auch, wie 16' in Fig. 2, etwas außermittig verlaufen kann.

Angestrebt ist jedoch, dass die Vertiefungen 16 vollständig innerhalb der zugehörigen Leiterbahn verlaufen, dass heißt umfangsseitig von der freien Oberfläche 12f der Leiterbahn 12 begrenzt werden.

Gemeinsam mit den gewölbten Flanken ergibt das eine optimierte Kraftverteilung mit Hilfe des entsprechenden Niederhalters während des Transportes und anschließenden Lötvorgangs.

Figur 5 zeigt eine Ausführungsform eines möglichen Niederhalters. An einer Traverse 20 ist eine Spiralfeder 22 angelenkt, die an ihrem freien Ende einen sphärischen Körper 24, hier in Form einer Kugel, trägt.

Der Körper 24 besteht aus glasfaserverstärktem Kunststoff, der bis 400° Celsius beständig ist, alternativ aus Keramik/Porzellan mit einer Temperaturbeständigkeit > 400° C. Das Material des Körpers 24 kann deshalb problemlos in einer Lötstation verwendet werden. Der Körper 24, der nach Absenken der Traverse 20 unter der Wirkung der Feder 22 flächig auf ein zugehöriges Lötband (eine Leiterbahn 12) drückt ermöglicht eine flächige, Kraftverteilung auf die Leiterbahn 12 beziehungsweise auf die zugehörige Solarzelle 10, wobei die in Figur 4 im Schnitt dargestellte Vertiefung 16 entsteht, aus der sich der Körper 24 nach Beendigung des Lötvorgangs problemlos wieder entfernen lässt. In Bezug auf die gewünschte Andrückkraft ist es vorteilhaft, wenn der Körper 24 exzentrisch zur Befestigung der Feder 22 an der Traverse 20 angeordnet ist, wie in Figur 5 dargestellt, also nicht nur eine unidirektionale Kraft entfaltet, wie im Fall einer rein vertikalen Beaufschlagung der Leiterbahn 12.

Es ist selbstverständlich, dass an der Traverse 20 mehrere der beschriebenen Niederhalter angeordnet sind, um eine entsprechende Vielzahl von Andrückflächen auf die entsprechenden Leiterbahnabschnitte zur Verfügung zu stellen.

## Patentansprüche

1. Solarzellen-String mit folgenden Merkmalen:
1.1 der String besteht aus mehreren, im Abstand hintereinander angeordneten Solarzellen (10),
1.2 benachbarte Solarzellen (10) sind jeweils über mindestens zwei elektrische Leiterbahnen (12) verbunden,
1.3 jede Leiterbahn (12) ist mit einem ersten Abschnitt (12o) mit einer Oberseite (10o) einer Solarzelle (10) fest verbunden und mit einem zweiten Abschnitt (12u) mit einer Unterseite (10u) der benachbarten Solarzelle (10) fest verbunden,
1.4 jede Leiterbahn (12) weist auf ihrem ersten Abschnitt (12o) mehrere, im Abstand zueinander verlaufende kalottenförmige Vertiefungen (16) auf, wobei
1.5 mindestens eine Vertiefung (16) gewölbte Flanken besitzt.

2. Solarzellen-String nach Anspruch 1, bei dem mindestens eine Vertiefung (16) vollständig innerhalb der zugehörigen Leiterbahn (12) verläuft.

3. Solarzellen-String nach Anspruch 1, bei dem mindestens eine Vertiefung (16) einen profilierten Wandabschnitt (16g) aufweist.

4. Solarzellen-String nach Anspruch 1, bei dem mindestens eine Vertiefung (16) im Bereich der freien Oberfläche (12f) der zugehörigen Leiterbahn (12) einen runden Querschnitt aufweist.

5. Solarzellen-String nach Anspruch 1, bei dem mindestens eine Vertiefung (16) im Bereich der freien Oberfläche (12f) der zugehörigen Leiterbahn (12) einen ovalen Querschnitt aufweist.

6. Solarzellen-String nach Anspruch 1, bei dem mindestens eine Vertiefung (16) im Bereich der freien Oberfläche (12f) der zugehörigen Leiterbahn einen evolventenförmigen Querschnitt aufweist.

7. Solarzellen-String nach Anspruch 1, bei dem die Vertiefungen (16) einen Abstand von 1,0 bis 3,0 cm aufweisen.

8. Solarzellen-String nach Anspruch 1, bei dem die Vertiefungen (16), senkrecht zur Leiterbahn-Oberfläche, eine Höhe aufweisen, die 0,1 bis 0,7 der Dicke der Leiterbahn (12), senkrecht zur Leiterbahn-Oberfläche, beträgt.

## Claims

1. Solar cell-string with following features:
1.1 the string provides several solar cells (10) arranged with a distance to each other one behind the other,
1.2 adjacent solar cells (10) are in each case connected by at least two conductor tracks (12),
1.3 each conductor track (12) is firmly connected with a first section (12o) to an upper surface (10o) of a solar cell (10) and with a second section (12u) to a lower surface (10u) of the adjacent solar cell (10),
1.4 each conductor track (12) has at its first section (12o) a series of spherically-shaped indentations, arranged with a distance to each other, wherein
1.5 at least one indentation (16) has curved zones.

2. Solar cell-string according to claim 1, with at least one indentation (16) extending completely within the corresponding conductor track (12).

3. Solar cell-string according to claim 1, wherein at least one indentation (16) has a profiled wall section (16g).

4. Solar cell-string according to claim 1, wherein at least one indentation (16) in the area of the free upper surface (12f) of the corresponding conductor track (12) has a circular cross-section.

5. Solar cell-string according to claim 1, wherein at least one indentation (16) in the area of the free upper surface (12f) of the corresponding conductor track (12) has an oval cross-section.

6. Solar cell-string according to claim 1, wherein at least one indentation (16) in the area of the free upper surface (12f) of the corresponding conductor track has an evolvent like shaped cross-section.

7. Solar cell-string according to claim 1, wherein the indentations (16) have a distance of 1,0 to 3,0 cm to each other.

8. Solar cell-string according to claim 1, wherein the indentations (16) have a height, perpendicular to the surface of the conductor track, that is 0,1 to 0,7 of the thickness of the conductor track (12) perpendicular to the conductor track surface.

## Revendications

1. Chaîne de cellules solaires avec les caractéristiques suivantes :
1.1. la chaîne est constituée de plusieurs cellules solaires (10), disposées à distance les unes derrière les autres,
1.2. des cellules solaires voisines (10) sont respectivement reliées par l'intermédiaire d'au moins deux pistes conductrices (12) électriques,
1.3. chaque piste conductrice (12) est reliée solidement par une première portion (12o) avec une face supérieure (10o) d'une cellule solaire (10) et reliée solidement par une deuxième portion (12u) avec une face inférieure (10u) de la cellule solaire voisine (10),
1.4. chaque piste conductrice (12) présente sur sa première portion (12o) plusieurs évidements (16) en forme de calotte s'étendant à distance les uns des autres, dans laquelle
1.5. au moins un évidement (16) possède des flancs bombés.

2. Chaîne de cellules solaires selon la revendication 1, dans laquelle au moins un évidement (16) s'étend complètement à l'intérieur de la piste conductrice (12) afférente.

3. Chaîne de cellules solaires selon la revendication 1, dans laquelle au moins un évidement (16) présente une portion de paroi (16g) profilée.

4. Chaîne de cellules solaires selon la revendication 1, dans laquelle au moins un évidement (16) présente au niveau de la surface à découvert (12f) de la piste conductrice afférente (12) une section transversale ronde.

5. Chaîne de cellules solaires selon la revendication 1, dans laquelle au moins un évidement (16) présente au niveau de la surface à découvert (12f) de la piste conductrice afférente (12) une section transversale ovale.

6. Chaîne de cellules solaires selon la revendication 1, dans laquelle au moins un évidement (16) présente au niveau de la surface à découvert (12f) de la piste conductrice afférente une section transversale en forme de développante.

7. Chaîne de cellules solaires selon la revendication 1, dans laquelle les évidements (16) présentent un écartement de 1.0 à 3.0 cm.

8. Chaîne de cellules solaires selon la revendication 1, dans laquelle les évidements (16), perpendiculairement à la surface de la piste conductrice, présentent une hauteur, qui est comprise entre 0,1 et 0,7 de l'épaisseur de la piste conductrice (12), perpendiculairement à la surface de la piste conductrice.
